Europäisches Patentamt

European Patent Office

Office européen des brevets

(11) Numéro de publication : **0 462 001 B1**

(12) **FASCICULE DE BREVET EUROPEEN**

(45) Date de publication du fascicule du brevet :
15.12.93 Bulletin 93/50

(51) Int. Cl.⁵ : **G01R 33/26**

(21) Numéro de dépôt : **91401559.9**

(22) Date de dépôt : **12.06.91**

(54) **Magnétomètre à résonance magnétique et à enroulements d'excitation multiplexes.**

(30) Priorité : **14.06.90 FR 9007412**

(43) Date de publication de la demande :
**18.12.91 Bulletin 91/51**

(45) Mention de la délivrance du brevet :
**15.12.93 Bulletin 93/50**

(84) Etats contractants désignés :
**BE DE GB IT NL SE**

(56) Documents cités :
**GB-A- 964 027**
**US-A- 3 284 699**
**US-A- 3 443 208**
**US-A- 4 814 707**
**IEEE TRANSACTIONS ON GEOSCIENCE**
**ELECTRONICS. vol. GE-16, no. 3, Juillet 1978,**
**NEW YORK US A.M.A. FRANDSEN ET AL.:**
**'The ISEE-C Vector Helium Magnetometer '**
**PATENT ABSTRACTS OF JAPAN vol. 12, no.**
**473 (P-799)(3320) 12 Décembre 1988 &**
**JP-A-63191981**
**D1: Physical Review, Vol. 57, p. 522-527**
**F.Bloch et al: "Magnetic Resonance for Non-**
**rotating Fields"**

(73) Titulaire : **COMMISSARIAT A L'ENERGIE
ATOMIQUE
31-33, rue de la Fédération
F-75015 Paris (FR)**

(72) Inventeur : **Beranger, Marc
63, rue des Ayguinards
F-38240 Meylan (FR)**
Inventeur : **Kernevez, Nelly
14, Boulevard Maréchal Leclerc
F-38000 Grenoble (FR)**
Inventeur : **Leger, Jean-Michel
510, rue des Ayguinards
F-38240 Meylan (FR)**
Inventeur : **Stoeckel, Frédéric
Chemin des Fourneaux, Belmont
F-38410 Uriage (FR)**

(74) Mandataire : **Signore, Robert et al
c/o BREVATOME 25, rue de Ponthieu
F-75008 Paris (FR)**

Jouve, 18, rue Saint-Denis, 75001 PARIS

## Description

La présente invention a pour objet un magnétomètre.

Elle trouve une application dans la mesure précise des champs magnétiques faibles (typiquement dans la plage de 20 à 70$\mu$T correspondant aux valeurs du champ magnétique terrestre).

Le magnétomètre de l'invention entre dans la catégorie des magnétomètres dits à résonance, dont on pourra trouver une description générale dans l'article de F. HARTMAN intitulé "Resonance Magnetometers", publié dans la revue "IEEE Transactions on Magnetics", vol. MAG-8, n° 1, March 1972, pp. 66-75.

Un magnétomètre à résonance est un appareil qui, plongé dans un champ magnétique Bo, délivre un signal électrique de fréquence F dont la valeur est liée à Bo par la relation dite de LARMOR :

$$F = \gamma Bo$$

où $\gamma$ est un rapport gyromagnétique (d'un électron ou d'un nucléon selon la substance utilisée). Pour l'électron par exemple, ce rapport est égal à 28Hz/nT.

L'excitation de la résonance magnétique est obtenue par un enroulement disposé autour de la substance utilisée et le prélèvement d'un signal de résonance s'effectue soit par un autre enroulement (variante électrique) soit par faisceau lumineux de pompage (variante optique).

Bien que l'invention s'applique à tous les types de magnétomètres à résonance magnétique, le magnétomètre à pompage optique sera plus spécialement pris comme exemple dans la suite, sans que la portée de l'invention en soit réduite pour autant.

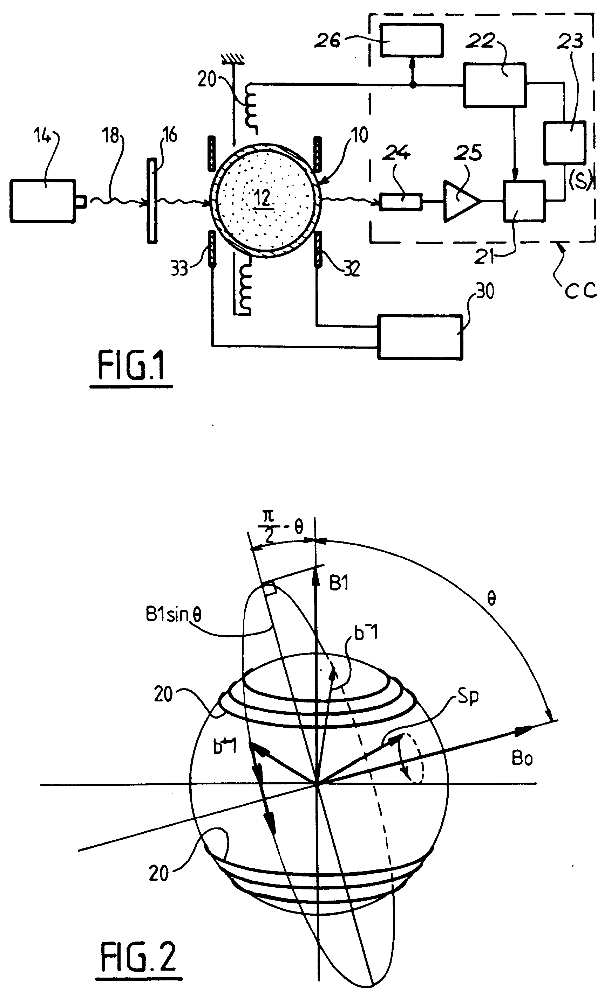

Un magnétomètre à pompage optique est représenté schématiquement sur la figure 1.

Une cellule 10, au moins partiellement transparente, est remplie d'un gaz 12, en général de l'hélium à une pression de 1 à quelques torrs. Une source lumineuse 14 délivre un faisceau lunineux 18 dont la longueur d'onde se situe autour de 1,1$\mu$m. Ce faisceau est convenablement polarisé par un moyen 16 puis injecté dans la cellule 10.

Par ailleurs, une décharge radio-fréquence (dite "faible" ou "douce") est produite dans le gaz par un générateur 30 relié à deux électrodes 32, 33 disposées autour de la cellule 10. Cette décharge produit des atomes dans un état métastable ($2^3S_1$ dans le cas de l'hélium). Le faisceau lumineux incident "pompe" ces atomes à partir de l'état métastable pour les amener dans un autre état excité ($2^3P$).

En présence d'un champ magnétique Bo, les niveaux d'énergie se séparent en sous-niveaux, dits de ZEEMAN. Une résonance entre de tels sous-niveaux peut être établie par un champ radio-fréquence (résonance magnétique) ou par une modulation de la lumière (double résonance optique ; COHEN, TANNOUDJI, Ann. Phys., 7, 1962, p. 423). Dans le cas de l'hélium isotope 4, la résonance s'établit entre deux sous-niveaux électroniques ZEEMAN de l'état métastable.

Cette résonance est mise en évidence par divers moyens connus de l'homme du métier, dont une variante est représentée sur la figure 1. Il s'agit d'un enroulement 20 disposé de part et d'autre de la cellule 10 (dans une disposition dite de HELMOLTZ), d'un générateur radio-fréquence 22, d'un photodétecteur 24 recevant le rayonnement lumineux ayant traversé la cellule, d'un amplificateur 25, d'une détection synchrone 21 et d'un intégrateur 23. L'ensemble des moyens 21 à 26 sera repéré par la suite par la référence CC. Le générateur 22 alimente l'enroulement 20 en courant à la fréquence F, ce qui crée un champ magnétique oscillant dont une composante entretient la résonance et module en retour le faisceau lumineux ayant traversé la cellule. Cette modulation constitue le signal. Elle est mise en évidence par la détection synchrone en sortie du photodétecteur via l'amplificateur. La référence est donnée par le générateur. La sortie de la détection synchrone correspondant à la composante du signal en phase avec la référence sert de signal d'erreur. L'intégrateur en élimine l'erreur statique. Ce signal d'erreur réajuste la fréquence F du synthétiseur à la fréquence de LARMOR. Il faut pour cela que le synthétiseur soit pilotable en tension ; il peut également être remplacé par un oscillateur commandé en tension (V.C.O.).

Un signal électrique de résonance S s'établit ainsi dans cette boucle, à la fréquence de LARMOR. Un fréquencemètre 26 en donne la valeur F. Le champ à mesurer Bo s'en déduit par la relation Bo=F/$\gamma$.

Les magnétomètres à hélium de ce type ont d'abord utilisé des lampes à hélium. L'obtention récente de cristaux d'aluminate de lanthane-néodyme (ou LNA) ayant permis de réaliser des lasers accordables autour de la longueur d'onde de 1,083$\mu$m correspondant précisément à la raie de pompage optique de l'hélium, ce type de laser s'est substitué tout naturellement à ces lampes avec une amélioration sensible des performances, ce qui a donné un regain d'intérêt à ces magnétomètres.

Un tel magnétomètre, équipé d'un laser à LNA, est décrit dans le document FR-A-2 598 518.

Bien que satisfaisants à certains égards, ces magnétomètres présentent cependant des inconvénients. Le principal d'entre eux est l'existence d'un décalage en fréquence dû à un effet dit de BLOCH-SIEGERT, causé par l'une des composantes du champ radio-fréquence d'excitation. Ce phénomène est illustré sur la figure 2, qui montre les orientations respectives des divers champs magnétiques mis en oeuvre.

Idéalement, le champ radio-fréquence B1 devrait être perpendiculaire au champ Bo à mesurer. En pratique, ces deux champs font entre eux un angle $\theta$. La composante de B1 projetée sur un plan perpendiculaire à Bo a donc pour amplitude B1 sin$\theta$ . L'amplitude

du signal de résonance dépend donc de l'angle entre le champ à mesurer et le champ de radio-fréquence : le magnétomètre n'est pas isotrope en amplitude.

Le champ alternatif B1 sinθ peut être considéré comme résultat de la composition de deux composantes circulaires $b^+1$ et $b^-1$ tournant en sens contraire. Seule l'une de ces composantes ($b^+1$ sur la figure 2) tourne dans le sens de précession des spins Sp et est capable d'entretenir la précession autour du champ Bo. L'autre composante $b^-1$ ne participe pas directement au phénomène de résonance, mais induit un décalage de fréquence. Ce décalage a pour valeur :

$$\Delta F = -\gamma \frac{B1^2}{4Bo} \sin^2\theta$$

C'est l'effet BLOCH-SIEGERT décrit dans la revue "Physical Review", 57, 1940, p. 522.

Lorsque l'orientation de la cellule (avec son enroulement varie, l'angle θ varie et le décalage en fréquence change : le magnétométre n'est pas isotrope en fréquence.

Pour illustrer l'ampleur de ce phénomène, on peut considérer, le cas d'un magnétomètre à hélium 4, (pour lequel la résonance est électronique le noyau de cet isotope étant dépourvu de spin), disposé dans une sphère de 6cm de diamètre. Le champ radio-fréquence B1 est créé par deux bobines de diamètre 4,5cm en position de HELMOLTZ, et éloignées de 2,25cm. Elles sont composées de trois spires de fil de cuivre de 0,5mm de diamètre. Lorsqu'elles sont parcourues par un courant de 10mA, le champ au centre de la cellule est de 600nT. A nos latitudes, le champ magnétique terrestre Bo est de 70μT.

Si θ =0°, le champ radio-fréquence B1 est parallèle au champ Bo, et il n'y a pas de signal de résonance.

Si θ=90°, le champ radio-fréquence B1 est perpendiculaire au champ Bo ; le signal de résonance est maximum, mais l'effet BLOCH-SIEGERT l'est aussi : le décalage en fréquence est de 55Hz, soit une erreur sur le champ Bo à mesurer de 2nT (environ $3.10^{-5}$).

Si θ=45°, le signal de résonance ne vaut plus que 70% de sa valeur maximale ; le décalage de fréquence est de 40Hz, soit une erreur sur le champ à mesurer de 1,4nT.

Cette anisotropie de fréquence peut être corrigée par des formules de compensation, si l'on est capable de déterminer la direction du champ statique Bo relativement au capteur, à l'aide de moyens appropriés (magnétomètre directionnel par exemple). Mais cette solution est lourde, coûteuse et difficile de mise en oeuvre car toute l'instrumentation doit être amagnétique et rigidement liée à la cellule (voir JP-A-63-191981).

La présente invention a justement pour but de remédier à ces inconvénients. A cette fin, l'invention propose un magnétomètre à résonance qui est isotrope en fréquence -c'est-à-dire débarrassé de l'erreur liée à l'effet BLOCH-SIEGERT- et qui reste léger et simple de mise en oeuvre.

Ce but est atteint, selon l'invention, par l'utilisation de trois enroulements d'excitation (au lieu d'un seul) dont les axes sont dirigés selon trois directions orthogonales (autrement dit, dont les axes forment un trièdre trirectangle). Ces enroulements sont multiplexés, c'est-à-dire mis en circuit les uns à la suite des autres.

Cette apparente complexité entraîne un avantage essentiel qui est le suivant. Chaque enroulement donne naissance à un signal de résonance qui lui est propre, avec une fréquence Fi (où i est un indice mis pour x, y ou z si l'on repère les axes des trois enroulements par les notations habituelles Oxyz). Cette fréquence Fi est en général entachée d'une erreur ΔFi, selon l'orientation de l'enroulement par rapport à Bo, comme exposé plus haut (sauf si l'un des axes des enroulements se trouve être rigoureusement perpendiculaire à Bo). Fi= γBo + ΔFi.

L'invention utilise la propriété selon laquelle la somme des erreurs ΔFx+ΔFy+ΔFz commises sur les trois fréquences Fx, Fy, Fz est indépendante de la direction du champ Bo. Cette somme est donnée par la quantité :

$$\sum_i F_i = -\gamma \frac{B1^2}{2Bo}$$

Ainsi, en prenant la moyenne des trois fréquences, soit 1/3(Fx+Fy+Fz), on obtient une quantité qui est indépendante de l'orientation de Bo : le magnétomètre est isotrope en fréquence.

De façon précise, la présente invention a donc pour objet un magnétomètre comprenant les moyens connus décrits plus haut et qui est caractérisé par le fait que l'enroulement d'excitation comprend trois enroulements ayant des axes formant un trièdre trirectangle Ox, Oy, Oz, le magnétomètre comprenant en outre un multiplexeur apte à relier séquentiellement chacun desdits trois enroulements au circuit d'excitation et des moyens pour mesurer la moyenne Fm des trois fréquences Fx, Fy, Fz des trois signaux de résonance correspondant aux trois enroulements, la valeur du champ magnétique ambiant Bo étant alors donnée par Bo=Fm/γ.

Selon un mode particulier de réalisation, les moyens aptes à mesurer la fréquence moyenne Fm mesurent en outre les trois fréquences Fx, Fy, Fz, ce qui permet d'obtenir des informations sur la direction du champ à mesurer Bo. Le magnétomètre n'est plus alors uniquement scalaire (c'est-à-dire donnant le module du champ) mais également vectoriel (c'est-à-dire donnant les composantes au champ sur les trois axes des enroulements).

Selon d'autres modes de réalisation, les moyens de mesure donne l'amplitude moyenne Am des trois signaux de résonance, amplitude dont la valeur n'est jamais nulle, quelle que soit l'orientation du champ, ce qui réduit l'anisotropie d'amplitude. Ces moyens peuvent donner en outre les trois amplitudes relatives aux trois enroulements, ce qui fournit encore des informations sur l'orientation du champ à mesurer dans le trièdre formé par les enroulements.

De toute façon, les caractéristiques et avantages de l'invention apparaîtront mieux à la lumière de la description qui va suivre. Cette description porte sur des exemples de réalisation, donné à titre explicatif et non limitatif. Elle se réfère par ailleurs à des dessins annexés sur lesquels :

- la figure 1, déjà décrite, représente un magnétomètre à résonance et à pompage optique selon l'art antérieur ;
- la figure 2, déjà décrite, illustre la disposition relative des divers champs magnétiques ;
- la figure 3 montre la disposition des trois enroulements d'excitation multiplexés selon l'invention ;
- la figure 4 montre un magnétomètre à résonance et à pompage optique selon l'invention ;
- la figure 5 est un chronogramme représentant différentes grandeurs dans un magnétomètre selon l'invention ;
- la figure 6 montre un mode de réalisation des moyens de mesure de la fréquence moyenne et de l'amplitude moyenne du signal de résonance ;
- la figure 7 montre un autre mode de réalisation des moyens de mesure de la fréquence moyenne et de l'amplitude moyenne du signal de résonance ;
- la figure 8 est un chronogramme correspondant au mode de réalisation de la figure 7 ;
- la figure 9 montre un mode de réalisation des moyens de mesure des trois fréquences des signaux de résonance, de la fréquence moyenne, des trois amplitudes et de l'amplitude moyenne ;
- la figure 10 est un chronogramme correspondant au mode de réalisation de la figure 9 ;
- la figure 11 montre un autre mode de réalisation des moyens de mesure des trois fréquences et de leur moyenne.

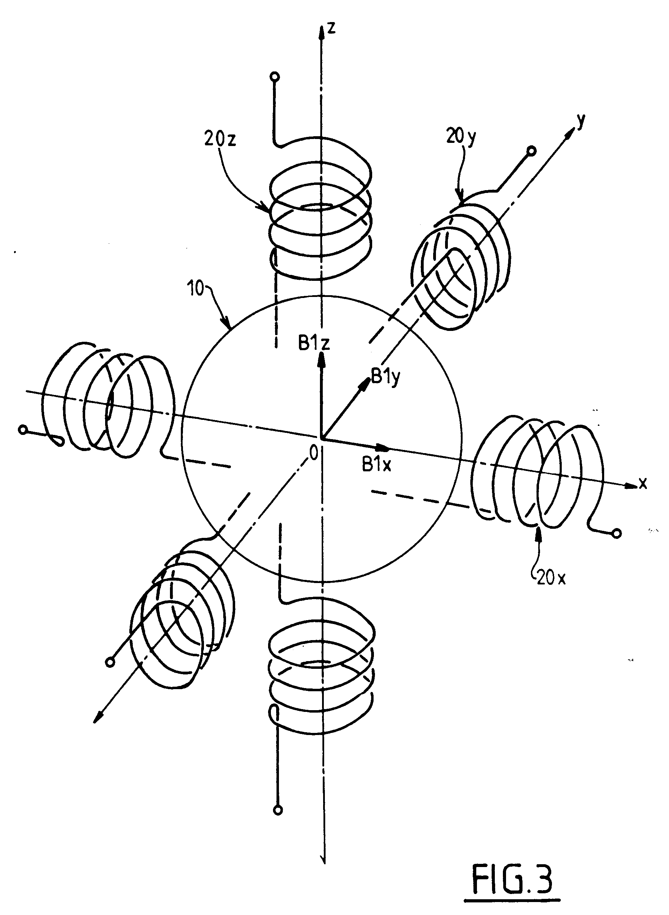

Le dispositif représenté sur la figure 3 montre les trois enroulements 20x, 20y, 20z utilisés conformément à l'invention. Ils sont représentés dans une disposition de HELMOLTZ, c'est-à-dire formés de deux demi-enroulements bobinés de part et d'autre de la cellule 10. Les axes de ces enroulements constituent un trièdre trirectangle Ox, Oy, Oz. Ces enroulements créent, lorsqu'ils sont parcourus par un courant, trois champs oscillants B1x, B1y, B1z, orthogonaux deux à deux.

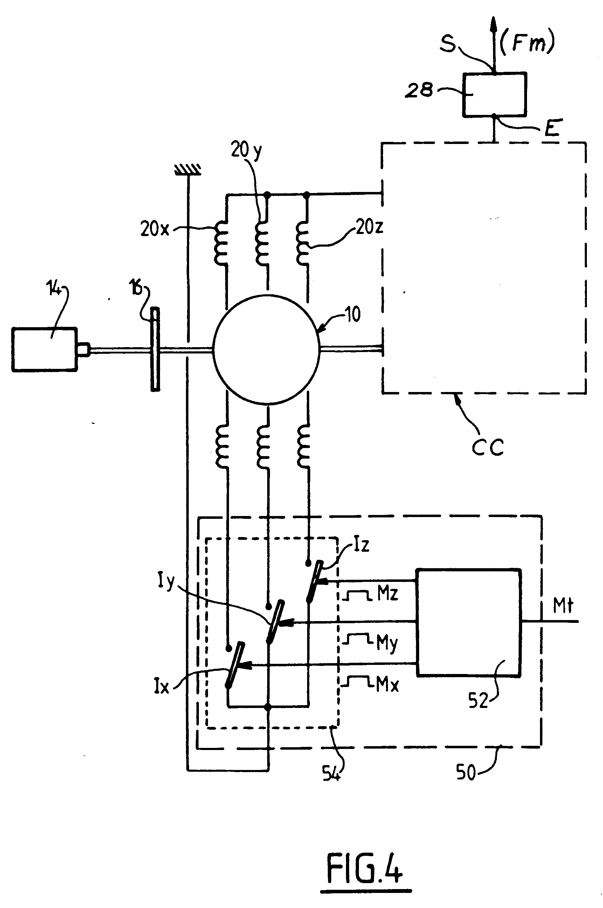

Un magnétomètre à résonance selon l'invention, dans le cas d'une variante à pompage optique, se présente alors comme illustré sur la figure 4. Il comprend tout d'abord des moyens connus déjà illustrés sur la figure 1 et qui portent, pour cette raison, les mêmes références numériques. Il s'agit de la cellule 10 remplie d'hélium, du laser 14, du moyen de polarisation 16 et du circuit CC (comprenant le générateur radio-fréquence 22, le photodétecteur 24, l'amplificateur 25, la détection synchrone 21 et l'intégrateur 23) et du générateur de décharge 30. Il comprend ensuite, et conformément à l'invention, trois enroulements 20x, 20y, 20z disposés en trièdre trirectangle autour de la cellule 10 (la représentation de la figure 4 est schématique à cet égard, mais il faut comprendre que la disposition réelle est conforme à celle de la figure 3). Ces trois enroulements sont mis en circuit par un multiplexeur 50, qui comprend schématiquement un générateur 52 de trois trains d'impulsions de multiplexage, respectivement Mx, My, Mz, (et éventuellement d'un quatrième train Mc dont le rôle apparaîtra plus loin) et de trois interrupteurs Ix, Iy, Iz aptes à mettre en service chacun des enroulements, c'est-à-dire à les relier au circuit d'excitation 52.

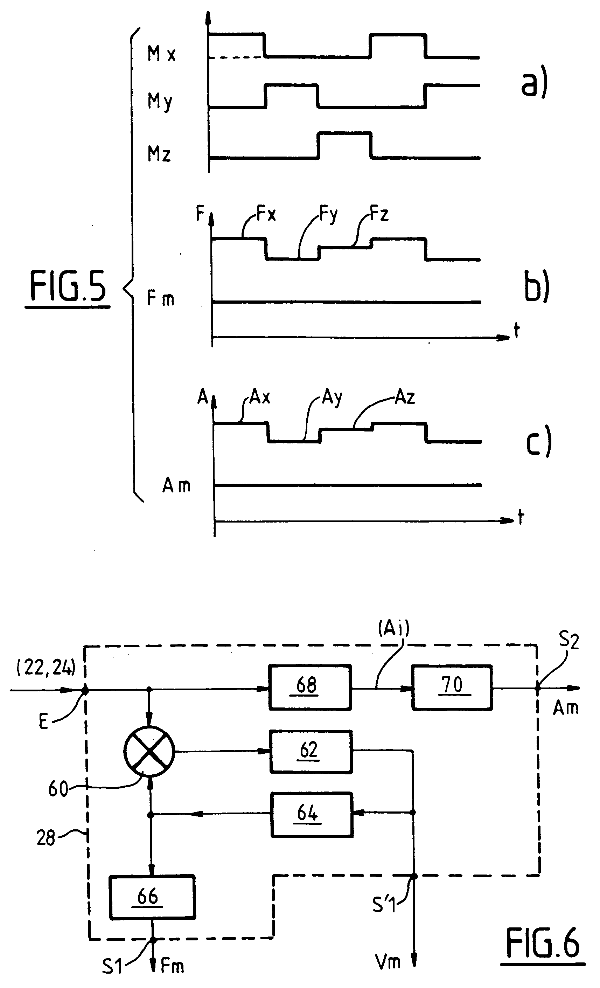

Les chronogrammes de la figure 5 expliquent le fonctionnement de ce dispositif. Sur la partie (a) sont représentés les trois trains d'impulsions de multiplexage Mx, My, Mz émis par le générateur 52. Les durées des impulsions définissent des intervalles de mise en circuit, ou de scrutation, des enroulements.

Les fréquences des signaux de résonance relatifs à ces enroulements sont représentées sur la partie (b). Comme expliqué plus haut, ces fréquences sont affectées d'une erreur, laquelle dépend de l'orientation de l'axe de l'enroulement par rapport au champ à mesurer. En général, donc, ces trois fréquences Fx, Fy, Fz sont différentes. La fréquence moyenne Fm est également représentée. Il est rappelé que, conformément à l'invention, elle ne dépend pas de l'orientation du champ.

Sur la partie (c) sont représentées les trois amplitudes Ax, Ay, Az correspondant aux trois signaux de résonance et l'amplitude moyenne Am. Compte tenu de la disposition choisie pour les enroulements, au moins deux d'entre eux fournissent un signal, et un au moins délivre un signal d'amplitude supérieure ou égale à 80% du signal maximum. Ce signal maximum est obtenu quand l'axe de l'enroulement est perpendiculaire au champ à mesurer.

Il convient de souligner que les directions pour lesquelles on obtient le signal le plus faible en amplitude sont également celles pour lesquelles le décalage en fréquence est minimal.

Quelques modes de réalisation des moyens 28 aptes à mesurer la fréquence moyenne Fm, vont maintenant être décrits en liaison avec les figures 6 à 11.

Selon la figure 6, tout d'abord, les moyens 28 pour mesurer la moyenne Fm comprennent une boucle à comparaison de phase avec un comparateur de phase 60, un filtre passe-bas 62, un oscillateur commandé en tension 64 (ou VCO en abrégé pour Voltage Controlled Oscillator) et un fréquencemètre 66.

Le moyen 28 peut comprendre en outre un détecteur d'amplitude 68 et un filtre passe-bas 70 dont la fréquence de coupure est nettement inférieure à la fréquence.

Le fonctionnement du circuit 28 est le suivant. Il reçoit sur une entrée E, le signal de résonance, lequel est modulé à la fois en fréquence et en amplitude à la fréquence de multiplexage (qui peut être de l'ordre de 1kHz). Une première sortie S1 délivre la fréquence recherchée Fm et une sortie annexe S'1 délivre une tension (celle qui est appliquée à l'oscillateur commandé en tension 64) reflètant cette fréquence. Le circuit 28 comprend encore une seconde sortie S2 délivrant l'amplitude moyenne Am.

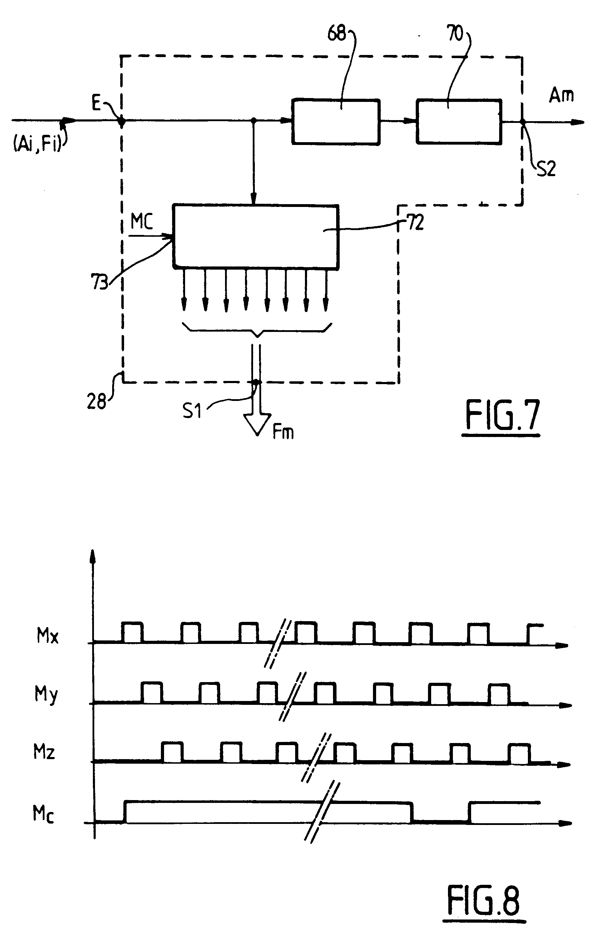

Selon une autre variante illustrée sur la figure 7, le moyen 28 comprend un fréquencemètre à comptage 72 ayant une entrée de commande 73 reliée au générateur 52 du multiplexeur 50 et recevant de celui-ci un signal de comptage Mc de durée très supérieure à la période des impulsions récurrentes de mise en circuit.

Le chronogramme de la figure 8 explique le fonctionnement de ce circuit. Les trois premières lignes montrent les trois trains d'impulsions de multiplexage Mx, My, Mz commandant la mise en circuit des trois enroulements et, par conséquent, les intervalles d'apparition d'un signal de résonance sur l'entrée E ; la quatrième ligne montre un signal de commande Mc, de durée très supérieure à la période des impulsions Mx, My et Mz. Par exemple, ces dernières auront une durée de 1ms et Mc une durée de 999ms.

Le fréquencemètre 72 compte tous les passages à zéro du signal pendant la durée de Mc. Le nombre d'impulsions est le même pour Mx, My ou Mz (dans l'exemple pris 999). Le nombre de passages compté reflète donc la fréquence moyenne Fm. Cette fréquence moyenne est obtenue sur la sortie S1.

Le traitement de l'amplitude moyenne s'effectue, comme pour la figure 6, par un détecteur d'amplitude 68 et un filtre passe-bas 70. La valeur de Am apparaît sur une sortie S2.

Selon une autre variante plus élaborée, les moyens 28 pour mesurer la fréquence moyenne Fm mesurent, en outre, les valeurs de chacune des trois fréquences Fx, Fy, Fz.

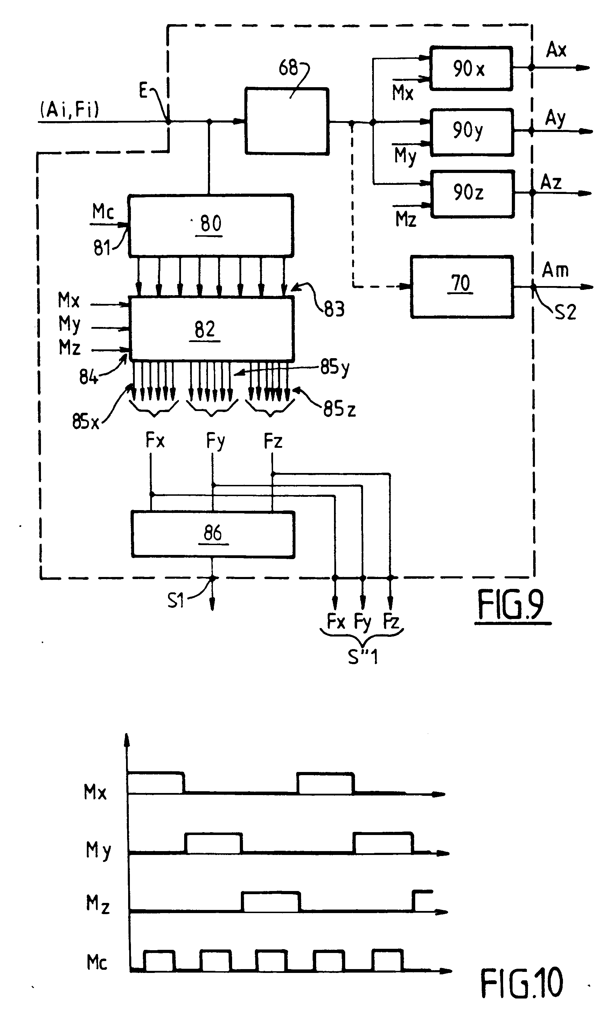

Selon un premier mode de réalisation de cette variante, qui est illustré sur la figure 9, les moyens 28 comprennent :
- un fréquencemètre à comptage 80, possédant une entrée de commande 81 reliée au générateur 52 du multiplexeur 50 d'où il reçoit une impulsion de commande de comptage Mc,
- un démultiplexeur 82, ayant une entrée numérique 83 reliée au fréquencemètre à comptage

80, trois entrées de commande 84 reliées au générateur 52 du multiplexeur 50 et recevant respectivement les impulsions Mx, My, Mz de commande des trois enroulements, trois sorties numériques 85x, 85y, 85z reliées à trois sorties générales S"1 délivrant les trois fréquences Fx, Fy, Fz,
- un sommateur-diviseur numérique 86, ayant trois entrées reliées aux trois sorties numériques du démultiplexeur et une sortie reliée à la sortie générale S1 délivrant la moyenne Fm des trois fréquences.

Le chronogramme de la figure 10 explique le fonctionnement de ce circuit. Sur les trois premières lignes figurent les trois signaux de multiplexage Mx, My, Mz pour la mise en service des enroulements. Sur la quatrième ligne est représenté le signal Mc de commande du fréquencemètre 80. La durée de ce signal est inférieure à celle des impulsions de multiplexage Mx, My, Mz. Il peut s'agir, par exemple, d'une durée de 1s, contre 2s pour le multiplexage.

Les informations délivrées par le fréquencemètre 80 sont donc successivement relatives à Fx, Fy et Fz. Ces informations numériques sont réparties sur trois voies numériques par le démultiplexeur 82, lequel est commandé par les impulsions de multiplexage Mx, My, Mz. On trouve donc, sur les sorties numériques 85x, 85y, 85z, les valeurs de Fx, Fy, Fz. Ces sorties sont reliées à la sortie générale S"1. Quant à la sortie générale S1, elle continue de délivrer la valeur de la fréquence moyenne Fm fournie par le sommateur-diviseur 86.

Dans le circuit de la figure 9, la voie de traitement de l'amplitude comprend, en plus du détecteur d'amplitude 68 et du filtre passe-bas 70, trois circuits d'échantillonnage et de maintien 90x, 90y, 90z commandés respectivement par les trois signaux de multiplexage Mx, My, Mz.

La chaîne 68, 70 délivre la valeur moyenne Am de l'amplitude sur la sortie générale S2 et les échantillonneurs-bloqueurs délivrant les valeurs Ax, Ay, Az des trois signaux de résonance.

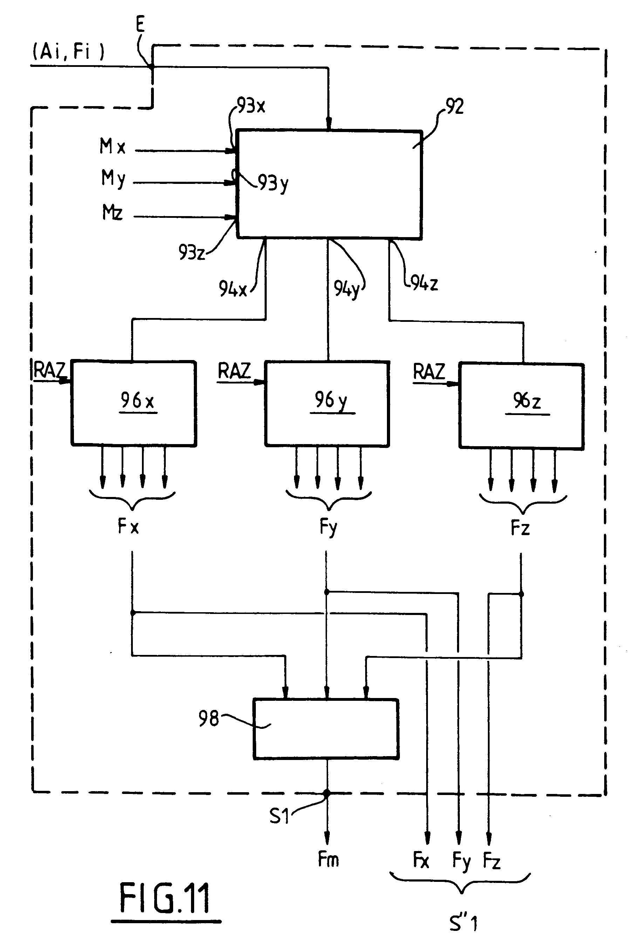

Selon un autre mode de réalisation illustré sur la figure 11, les moyens pour mesurer chacune des trois fréquences ainsi que la moyenne de ces fréquences comprennent :
- un démultiplexeur 92 à une entrée recevant le signal de mesure, trois entrées de commande 93x, 93y, 93z reliées au générateur 52 du multiplexeur 50 et recevant les trois impulsions Mx, My, Mz de mise en circuit de ces enroulements et à trois sorties 94x, 94y, 94z délivrant respectivement trois signaux de mesure,
- trois fréquencemètres à comptage 96x, 96y, 96z reliés respectivement aux trois sorties 94x, 94y, 94z du démultiplexeur 92 et délivrant respectivement les trois fréquences Fx, Fy, Fz sur une sortie S"1,

- un sommateur-diviseur numérique 98 relié aux trois fréquencemètres 96x, 96y, 96z et délivrant la moyenne des fréquences Fm sur une sortie générale S1.

## Revendications

1. Magnétomètre à résonance magnétique comprenant une cellule (10) remplie d'une substance (12) ayant un rapport gyromagnétique $\gamma$ et susceptible de présenter un phénomène de résonance magnétique en présence d'un champ magnétique ambiant (Bo), la résonance s'établissant à la fréquence $F=\gamma Bo$, des moyens d'excitation de cette résonance comprenant un enroulement (20) bobiné autour de la cellule (10) et des moyens d'excitation (21 à 25) de cet enroulement (20) par un signal de résonance et des moyens (26) pour mesurer la fréquence du signal de résonance, ce magnétomètre étant caractérisé par le fait que l'enroulement d'excitation (20) comprend trois enroulements (20x, 20y, 20z) ayant des axes formant un trièdre trirectangle (Ox, Oy, Oz), le magnétomètre comprenant en outre un multiplexeur (50) apte à relier séquentiellement chacun desdits trois enroulements au circuit d'excitation (22) et des moyens (28) pour mesurer la moyenne (Fm) des trois fréquences (Fx, Fy, Fz) des trois signaux de résonance correspondant aux trois enroulements (20x, 20y, 20z), la valeur du champ magnétique ambiant (Bo) étant alors donnée par Bo=Fm/$\gamma$.

2. Magnétomètre selon la revendication 1, caractérisé par le fait que le multiplexeur comprend un générateur (52) délivrant trois trains d'impulsions récurrentes (Mx, My, Mz) de mise en circuit respectivement des trois enroulements (20x, 20y, 20z), ces trois trains d'impulsions récurrentes occupant des intervalles de temps distincts.

3. Magnétomètre selon la revendication 1, caractérisé par le fait que les moyens (28) pour mesurer la moyenne (Fm) comprennent une boucle à comparaison de phase avec un comparateur de phase (60), un filtre passe-bas (62), un oscillateur commandé en tension (64) et un fréquencemètre (66).

4. Magnétomètre selon la revendication 2, caractérisé par le fait que les moyens pour mesurer la fréquence moyenne (Fm) comprennent un fréquencemètre à comptage (72) ayant une entrée de commande (73) reliée au générateur (52) du multiplexeur (50) et recevant de celui-ci un signal de comptage (Mc) de durée très supérieure à la période des impulsions récurrentes de mise en circuit.

5. Magnétomètre selon la revendication 1, caractérisé par le fait que les moyens (28) pour mesurer la moyenne (Fm) des trois fréquences mesurent, en outre, les valeurs de chacune des trois fréquences (Fx, Fy, Fz).

6. Magnétomètre selon la revendication 5, caractérisé par le fait que les moyens (28) pour mesurer chacune des trois fréquences et la moyenne de ces trois fréquences comprennent :
   - un fréquencemètre à comptage (80) possédant une entrée de commande (81) reliée à un générateur (52) du multiplexeur (50) d'où il reçoit une impulsion de commande de comptage (Mc) intervenant pendant les impulsions (Mx, My, Mz) de mise en service des trois enroulements et de durée inférieure à celle de ces impulsions,
   - un démultiplexeur (82) ayant une entrée numérique (83) reliée au fréquencemètre à comptage (80), trois entrées de commande (84) reliées au générateur (52) du multiplexeur (50) et recevant respectivement les impulsions (Mx, My, Mz) de commande des trois enroulements, trois sorties numériques (85x, 85y, 85z), ces trois sorties numériques étant reliées à trois sorties générales (s(x), s(y), s(z)) délivrant les trois fréquences (Fx, Fy, Fz),
   - un sommateur-diviseur numérique (86) ayant trois entrées reliées aux trois sorties numériques de la bascule et une sortie reliée à la sortie générale (s1) de ces moyens (28) et délivrant la moyenne (Fm) des trois fréquences.

7. Magnétomètre selon la revendication 5, caractérisé par le fait que les moyens pour mesurer chacune des trois fréquences ainsi que la moyenne de ces fréquences comprennent :
   - un démultiplexeur (92) à une entrée recevant le signal de mesure, trois entrées de commande (93x, 93y, 93z) reliées à un générateur (52) du multiplexeur (50) et recevant les trois impulsions (Mx, My, Mz) de mise en circuit de ces enroulements et à trois sorties (94x, 94y, 94z) délivrant respectivement trois signaux de mesure,
   - trois fréquencemètres à comptage (96x, 96y, 96z) reliés respectivement aux trois sorties (94x, 94y, 94z) du démultiplexeur (92) et délivrant respectivement les trois fréquences (Fx, Fy, Fz), sur une sortie (S''1),
   - un sommateur-diviseur numérique (98) relié aux trois fréquencemètres (96x, 96y, 9bz) et délivrant la moyenne des fréquences (Fm) sur une sortie générale (S1).

8. Magnétomètre selon la revendication 1, caractérisé par le fait qu'il comprend en outre des moyens pour mesurer la moyenne (Am) des trois amplitudes (Ax, Ay, Az) des trois signaux de résonance correspondant aux trois enroulements.

9. Magnétomètre selon la revendication 8, caractérisé par le fait que les moyens pour mesurer la moyenne (Am) comprennent un détecteur d'amplitude (68) suivi d'un filtre passe-bas (70).

10. Magnétomètre selon la revendication 8, caractérisé par le fait que les moyens pour mesurer l'amplitude moyenne (Am) des trois amplitudes comprennent en outre des moyens pour mesurer séparément ces trois amplitudes.

11. Magnétomètre selon la revendication 10, caractérisé par le fait que les moyens pour mesurer les trois amplitudes sont constitués par trois circuits d'échantillonnage et de maintien (90x, 90y, 90z) commandés par les trois signaux de commande émis par le multiplexeur.

12. Magnétomètre selon l'une quelconque des revendications 1 à 11, caractérisé par le fait que le magnétomètre est du type à pompage optique et comprend une source lumineuse (14) émettant un faisceau lumineux, un polariseur (16) et un photodétecteur (24) recevant le faisceau après sa traversée de la cellule.

**Patentansprüche**

1. Magnetometer mit magnetischer Resonanz, umfassend eine Zelle (10), gefüllt mit einer Substanz mit einem gyromagnetischen Verhaltnis $\gamma$ und fähig, ein Phänomen magnetischer Resonanz aufzuweisen bei Vorhandensein eines magnetischen Umgebungsfelds (Bo), wobei die Resonanz sich einstellt auf die Frequenz F= $\gamma$ Bo, Erregereinrichtungen dieser Resonanz, umfassend eine Wicklung (20), gespult um die Zelle (10), und Einrichtungen (21 bis 25) zur Erregung dieser Wicklung (20) durch ein Resonanzsignal, und Meßeinrichtungen (26) zur Messung der Frequenz des Resonanzsignals, wobei dieses Magnetometer dadurch **gekennzeichnet** ist, daß die Erregerwicklung (20) drei Wicklungen (20x, 20y, 20z) umfaßt, deren Achsen einen Trieder mit drei rechten Winkeln bilden (Ox, Oy, Oz), und das Magnetometer außerdem einen Multiplexer (50) enthält, imstande, jede der genannten drei Wicklungen in Folge mit dem Erregerkreis (22) zu verbinden, und Einrichtungen, um das Mittel (Fm) der drei Frequenzen (Fx, Fy, Fz) der drei Resonanzsignale zu messen, die den drei Wicklungen (20x, 20y, 20z) entsprechen, wobei der Wert des magnetischen Umfelds (Bo) sich dann ergibt aus Bo=Fm/ $\gamma$ .

2. Magnetometer nach Anspruch 1, dadurch gekennzeichnet, daß der Multiplexer einen Generator (52) enthält, der drei unendlich periodische Impulsfolgen (Mx, My, Mz) für die jeweilige Zuschaltung der drei Wicklungen (20x, 20y, 20z) liefert, wobei diese unendlich periodischen Impulsfolgen verschiedene Zeitintervalle belegen.

3. Magnetometer nach Anspruch 1, dadurch gekennzeichnet, daß die Einrichtungen (28) zum Messen des Mittels (Fm) eine Phasenvergleichsschleife mit einem Phasenkomparator (60), einen Tiefpaßfilter (62), einen spannungsgeregelten Schwinger (64) und einen Frequenzmesser (66) enthalten.

4. Magnetometer nach Anspruch 2, dadurch gekennzeichnet, daß die Einrichtungen zum Messen der mittleren Frequenz (Fm) einen Zähl-Frequenzmesser (72) enthält mit einem Steuereingang (73), der verbunden ist mit dem Generator (52) des Multiplexers (50), und von diesem ein Zählsignal (Mc) erhält, dessen Dauer dreimal größer ist als die Periode der unendlich periodischen Zuschaltimpulse.

5. Magnetometer nach Anspruch 1, dadurch gekennzeichnet, daß die Einrichtungen zur Messung des Mittels (Fm) der drei Frequenzen außerdem die Werte von jeder der drei Frequenzen (Fx, Fy, Fz) messen.

6. Magnetometer nach Anspruch 5, dadurch gekennzeichnet, daß die Einrichtungen (28) zum Messen von jeder der drei Frequenzen und dem Mittel dieser drei Frequenzen umfassen:
   - einen Zähl-Frequenzmesser (80) mit einem Steuereingang (81), verbunden mit einem Generator (52) des Multiplexers (50), von wo er einen Zähl-Steuerimpuls (Mc) erhält, der während der Impulse (Mx, My, Mz) des Zuschaltens der drei Wicklungen erfolgt und dessen Dauer kleiner ist als die der Impulse,
   - einen Demultiplexer (82) mit einem numerischen Eingang (83), verbunden mit dem Zähl-Frequenzmesser (80), drei Steuereingänge (84), verbunden mit dem Generator (52) des Multiplexers (50) und jeweils die Steuerimpulse (Mx, My, Mz) der drei Wicklungen empfangend, drei numerische Ausgänge (85x, 85y, 85z), wobei diese drei numerischen Ausgänge verbunden sind mit drei Hauptausgängen (s(x), s(y), s(z)), die drei Frequenzen (Fx, Fy, Fz) liefernd,
- einen numerischen Summierer-Dividierer (86) mit drei Eingängen, verbunden mit den drei numerischen Ausgängen der Kippschaltung und einem Ausgang, verbunden mit dem Hauptausgang (sl) dieser Mittel (28) und das Mittel (Fm) der drei Frequenzen liefernd.

7. Magnetometer nach Anspruch 5, dadurch gekennzeichnet, daß die Einrichtungen zum Messen jeder der drei Frequenzen sowie des Mittels dieser drei Frequenzen umfassen:
- einen Demultiplexer (92) mit einem das Meßsignal empfangenden Eingang, drei Steuereingänge (93x, 93y, 93z), verbunden mit einem Generator (52) des Multiplexers (50) und die drei Zuschaltimpulse (Mx, My, Mz) dieser Wicklungen empfangend und mit drei Ausgängen (94x, 94y, 94z), jeweils drei Meßsignale liefernd,
- drei Zähl-Frequenzmesser (96x, 96y, 96z), jeweils verbunden mit den drei Ausgängen (94x, 94y, 94z) des Demultiplexers (92), und jeweils die drei Frequenzen (Fx, Fy, Fz) an einem Ausgang (S"1) liefernd,
- einen numerischen Summierer-Dividierer (98), verbunden mit drei Frequenzmessern (96x, 96y, 96z), und das Mittel der Frequenzen (Fm) an einem Hauptausgang (S1) liefernd.

8. Magnetometer nach Anspruch 1, dadurch gekennzeichnet, daß es außerdem Einrichtungen für die Messung des Mittels (Am) der drei Amplituden (Ax, Ay, Az) der drei den drei Wicklungen entsprechenden Resonanzsignale enthält.

9. Magnetometer nach Anspruch 8, dadurch gekennzeichnet, daß die Einrichtungen zur Messung des Mittels (Am) einen Amplitudendetektor (68) enthalten, gefolgt von einem Tiefpaßfilter (70).

10. Magnetometer nach Anspruch 8, dadurch gekennzeichnet, daß die Einrichtungen zur Messung der Durchschnittsamplitude (Am) der drei Amplituden außerdem Einrichtungen enthalten, um diese drei Amplituden getrennt zu messen.

11. Magnetometer nach Anspruch 10, dadurch gekennzeichnet, daß die Einrichtung zum Messen der drei Amplituden gebildet werden durch drei Musternahme- und Halteschaltkreise (90x, 90y, 90z), gesteuert durch die drei von dem Multiplexer ausgegebenen Steuersignale.

12. Magnetometer nach einem der Ansprüche 1 bis 11, dadurch gekennzeichnet, daß das Magnetometer typmäßig ein optisch gepumptes Magnetometer ist und eine, ein Strahlenbündel aussendende Lichtquelle (14), einen Polarisator (16) und einen Photodetektor (24) umfaßt, der das Bündel empfängt nach seiner Durchquerung der Zelle.

## Claims

1. Magnetic resonance magnetometer incorporating a cell (10) filled with a substrate (12) having a gyromagnetic ratio $\gamma$ and which can have a magnetic resonance phenomenon in the presence of an ambient magnetic field (Bo), the resonance being established at the frequency F= $\gamma$ Bo, exciting means for said resonance incorporating a winding (20) wound around the cell (10) and means (21 to 25) for exciting the said winding (20) by a resonance signal and means (26) for measuring the frequency of the resonance signal, said magnetometer being characterized in that the exciting winding (20) comprises three windings (20x, 20y,20z) having axes forming a trirectangular trihedron (Ox,Oy,Oz), the magnetometer also having a multiplexer (50) able to sequentially connect each the three windings to the exciting circuit (22) and means (28) for measuring the mean value (Fm) of the three frequencies (Fx,Fy,Fz) of the three resonance signals coresponding to the three windings (20x, 20y,20z), the value of the ambient magnetic field (Bo) then being given by Bo= Fm/$\gamma$ .

2. Magnetometer according to claim 1, characterized in that the multiplexer comprises a generator (52) supplying three recurrent pulse trains (mx,My,Mz) for respectively switching on the three windings (20x,20y,20z), said three recurrent pulse trains occupying separate time intervals.

3. Magnetometer according to claim 1, characterized in that the means (28) for measuring the mean value (Fm) incorporate a phase comparison loop with a phase comparator (60), a lowpass filter (62), a voltage-controlled oscillator (64) and a frequency meter (66).

4. Magnetometer according to claim 2, characterized in that the means for measuring the mean frequency (Fm) incorporate a counting frequency meter (72) having a control input (73) connected to the generator (52) of the multiplexer (50) and receiving threfrom a counting signal (Mc) having a duration greatly in excess of that of the recurrent switching on pulses.

**5.** Magnetometer according to claim 1, characterized in that the means (28) for measuring the mean value (Fm) of the three frequencies also measures the value of each of the three frequencies (Fx,Fy and Fz).

**6.** Magnetometer according to claim 5, characterized in that the means (28) for measuring each of the three frequencies and the mean value of these three frequencies comprises:
- a counting frequency meter (80) having a control input (81) connected to a generator (52) of the multiplexer (50) from which it receives a counting control pulse (Mc) occurring during the pulses (Mx,My,Mz) for putting into operation the three windings and having a duration less than that of the pulses,
- a demultiplexer (82) having a digital input (83) connected to the counting frequency meter (80) three control inputs (84) connected to the generator (52) of the multiplexer (50) and respectively receiving the control pulses (Mx,My,Mz) from the three windings, three digital outputs (85x,85y,85z), said three digital outputs being connected to three general outputs (s(x), s(y), s(z)) supplying the three frequencies (Fx,Fy,Fz),
- a digital adder - divider (86) having three inputs connected to the three digital outputs of the flip-flop and an output connected to the general output (F1) of the said means (28) and supplying the means value (Fm) of the three frequencies.

**7.** Magnetometer according to claim 5, characterized in that the means for measuring each of the three frequencies and the mean value of these three frequencies comprise:
- a demultiplexer (92) having an input receiving the measurement signal, three control inputs (93x,93y,93z) connected to a generator (52) of the multiplexer (50) and receiving the three pulses (Mx,My,Mz) for putting into operation the said windings and having three outputs (94x,94y,94z) respectively supplying three measurement signals,
- three counting frequency meters (96x,96y, 96z) respectively connected to the three outputs (94x,94y,94z) of the demultiplexer (92) and respectively applying the three frequencies (Fx,Fy, Fz) on an output (S"1),
- a digital adder - divider (98) connected to the three frequency meters (96x,96y,96z) and supplying the mean value of the frequency (Fm) on a general output (S1).

**8.** Magnetometer according to claim 1, characterized in that it also comprises means for measuring the mean value (Am) of the three amplitudes (Ax,Ay,Az) of the three resonance signals corresponding to the three windings.

**9.** Magnetometer according to claim 8, characterized in that the means for measuring the mean value (Am) comprise an amplitude detector (68) followed by a low-pass filter (70).

**10.** Magnetometer according to claim 8, characterized in that the means for measuring the mean amplitude (Am) of the three amplitudes also comprises means for separately measuring these three amplitudes.

**11.** Magnetometer according to claim 10, characterized in that the means for measuring the three amplitudes are constituted by three sample and hold circuits (90x,90y,90z) controlled by the three control signals emitted by the multiplexer.

**12.** Magnetometer according to any one of the claims 1 to 11, characterized in that the magnetometer is of the optical pumping type and comprises a light source (14) emitting a light beam, a polarizer (16) and a photodetector (24) recieving the beam after it has passed through the cell.

FIG.1

FIG.2

FIG.3

FIG.4

FIG.5

a)

b)

c)

FIG.6

FIG.7

FIG.8

FIG.9

FIG.10

FIG.11